# EUROPÄISCHE PATENTANMELDUNG

(11) **EP 4 372 121 A2**
(43) Veröffentlichungstag der Anmeldung: **22.05.2024**
(21) Anmeldenummer: 23203999.0
(22) Anmeldetag: 17.10.2023
(51) Int. Cl.: C23C 14/50, C23C 14/52, C23C 14/54, C23C 16/458, C23C 16/52, H01L 21/67, G01K 7/02

(54) **WAFER-CHUCK, TRÄGER UND VERFAHREN**

(30) Priorität: 25.10.2022 DE 102022128091
(71) Anmelder: Technische Universität Dresden Körperschaft des öffentlichen Rechts, 01069 Dresden (DE)
(72) Erfinder: KNAUT, Martin, 01187 Dresden (DE)
(74) Vertreter: Viering, Jentschura & Partner mbB Patent- und Rechtsanwälte

(57) **Zusammenfassung**

Ein Träger (100), ein Wafer-Chuck (200) und ein Verfahren (500) werden offenbart, wobei das Verfahren (500) aufweist: Einschleusen (502) eines Trägers (100) in eine Prozesskammer (402), wobei der Träger (100) aufweist: eine Trägerplatte (102), einen auf der Vorderseite (V) der Trägerplatte (102) angeordneten Schwingquarz (104), und einen ersten Elektrodenkontakt (106) und einen zweiten Elektrodenkontakt (108) zum Kontaktieren des Schwingquarzes (104); Koppeln (502) (z.B. in Kontakt bringen) des ersten Elektrodenkontaktes (106) und des zweiten Elektrodenkontaktes (108) mit einer in der Prozesskammer (402) angeordneten Schnittstelle (210); und Anlegen (504) eines Sensorsignals an den Schwingquarz (104) mittels der Schnittstelle (210).

## Beschreibung

Verschiedene Ausführungsbeispiele betreffen einen Wafer-Chuck, einen Träger und ein diesbezügliches Verfahren.

In Schichtabscheidungsanlagen, in denen eine physikalische Gasphasenabscheidung (PVD) durchgeführt wird, kann eine Quarzkristall-Mikrowaage in der Schichtabscheidungsanlagen fest verbaut sein (z.B. mittels eines Flansches und entsprechender Kontaktierung), um die Schichtdicke und/oder Schichtabscheidungsrate während der physikalischen Gasphasenabscheidung (also in situ) zu erfassen. Allerdings ist dies bei Schichtabscheidungsanlagen, welche eine chemische Gasphasenabscheidung (CVD oder ALD) durchführen, aus verschiedenen Gründen nicht möglich. Einerseits ist die Schichtabscheidungsrate (und damit die Schichtdicke) von der Temperatur des Substrats abhängig, so dass aufgrund von Temperaturunterschieden zwischen dem Substrat und der fest verbauten Quarzkristall-Mikrowaage keine genauen Messungen möglich sind. Auch (möglicherweise auch aus dem vorgenannten Grund) verfügen herkömmliche CVD- oder ALD-Anlagen über keine entsprechenden Schnittstellen (z.B. Flansche), an welche eine solche Quarzkristall-Mikrowaage angebaut werden kann, und auch nicht über ausreichend Platz innerhalb der CVD-Anlagen zum Einbau einer solchen Quarzkristall-Mikrowaage. Häufig sind daher in CVD-Anlagen aus den voranstehend genannten Gründen keine (in situ) Schichtdickenmessungen mittels Quarzkristall-Mikrowaagen möglich. Ist keine Quarzkristall-Mikrowaage in der CVD-Anlage angeordnet, kann die Schichtdicke nur nach der Schichtabscheidung ex situ gemessen werden. Die Schichtdickenänderung (z.B. Schichtabscheidungsrate) während der Beschichtung kann in diesem Fall nicht erfasst werden.

Gemäß verschiedenen Ausführungsformen werden ein Träger, ein Wafer-Chuck und ein Verfahren bereitgestellt, welche es ermöglichen, die Schichtdicke und/oder die Schichtdickenänderung auch im Fall eines CVD-Beschichtungsverfahrens in situ zu erfassen.

Hierbei ist mindestens ein (z.B. als Quarzkristall-Mikrowaage fungierender) Schwingquarz auf einem Träger angeordnet und der Träger weist auf seiner Rückseite entsprechende Kontakte zum Kontaktieren des Schwingquarzes auf. Diese Kontakte können mittels zugeordneten Kontakten des Wafer-Chucks kontaktiert werden, wenn der Träger auf dem Wafer-Chuck angeordnet ist.

Dies ermöglich ebenfalls, dass der Einfluss mehrerer nacheinander durchgeführter Prozessierungen (z.B. Schichtabscheidungen (z.B. CVD- und/oder PVD-Schichtabscheidungen) und/oder Ätzverfahren) direkt mittels derselben ein oder mehreren Schwingquarze erfasst werden kann. Dies erhöht die Genauigkeit der Messungen im Vergleich zur Verwendung verschiedener Schwingquarze in verschiedenen Kammer (wobei dies auch nur im Falle von verschiedenen PVD-Beschichtungsverfahren überhaupt möglich ist).

Auch verringert das Ein- und Ausschleusen des Trägers mit dem Schwingquarz den für das Tauschen von Quarzkristall-Mikrowaagen erforderlichen Zeitaufwand im Vergleich zu einem Ausbau von fest verbauten Quarzkristall-Mikrowaagen. Folglich stellen der Träger, der Wafer-Chuck und das Verfahren, wie hierin beschrieben, eine erhöhte Flexibilität bereit.

Es zeigen
Figuren 1A bis 1I einen Träger gemäß verschiedenen Ausführungsformen;
Figuren 2A bis 2C einen Wafer-Chuck gemäß verschiedenen Ausführungsformen;
Figur 3 ein System, bei dem ein Träger auf einem Wafer-Chuck angeordnet ist, gemäß verschiedenen Ausführungsformen;
Figuren 4A und 4B eine Prozessiervorrichtung gemäß verschiedenen Ausführungsformen; und
Figur 5 ein Ablaufdiagramm eines Verfahrens gemäß verschiedenen Ausführungsformen.

In der folgenden ausführlichen Beschreibung wird auf die beigefügten Zeichnungen Bezug genommen, die Teil dieser bilden und in denen zur Veranschaulichung spezifische Ausführungsformen gezeigt sind, in denen die Erfindung ausgeübt werden kann.

Verschiedene Ausführungsformen betreffen einen Träger, einen Wafer-Chuck und ein Verfahren, mittels welchen eine Schichtdicke und/oder eine Schichtdickenänderung (in situ) während eines Beschichtungsverfahrens und/oder eines Ätzverfahrens erfasst werden können.

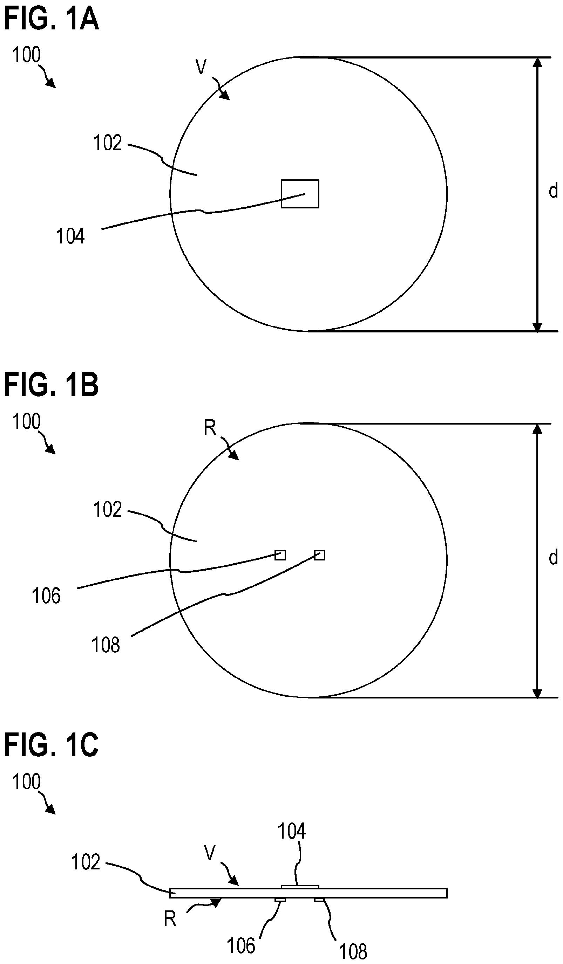

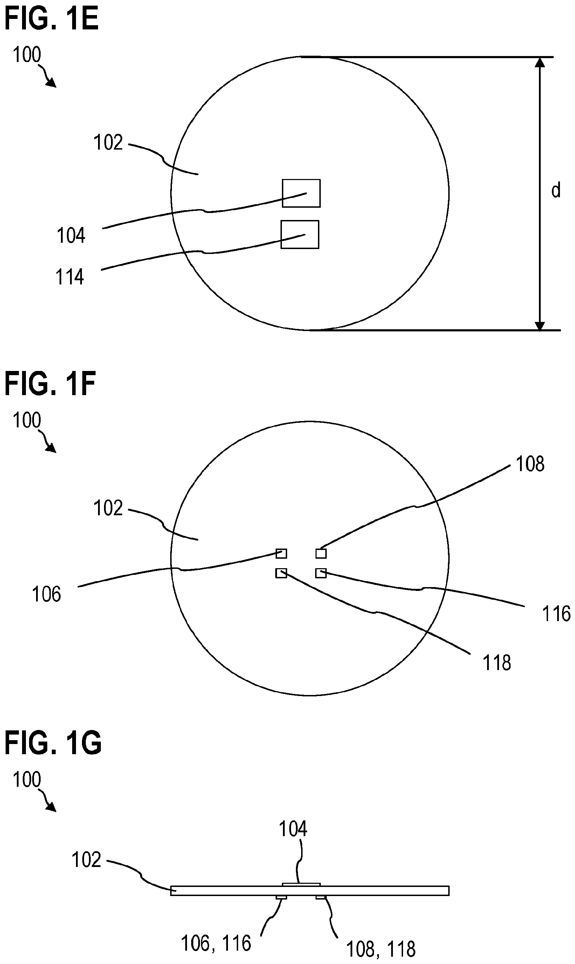

**FIG.1A** bis **FIG.1C** zeigen einen Träger 100 gemäß verschiedenen Ausführungsformen. Hierbei zeigt FIG.1A eine Frontansicht, FIG.1B eine Rückansicht, und FIG.1C eine Seitenansicht des Trägers 100. Der Träger 100 kann eine Trägerplatte 102 aufweisen. Die Trägerplatte 102 kann zum Beispiel ein Wafer (z.B. ein Wafer in einem beliebigen Fertigungszustand) oder ein anderes Substrat (z.B. ein Glassubstrat) sein. Die Trägerplatte 102 kann eine erste Seite (im Folgenden als Vorderseite, V, bezeichnet) und eine der ersten Seite gegenüberliegende zweite Seite (im Folgenden als Rückseite, R, bezeichnet) aufweisen. Zur Veranschaulichung ist die Trägerplatte in den Figuren als runder Träger (z.B. als Wafer) dargestellt. Es wird verstanden, dass die Trägerplatte 102 auch jede andere Form (z.B. rechteckig, z.B. quadratisch) aufweisen kann. Die Trägerplatte 102 kann jede gewünschte (z.B. an den in einer Prozesskammer angeordneten Wafer-Chuck angepasste) Größe aufweisen. Zum Beispiel in dem Fall eines Wafers kann die Trägerplatte 102 jeden beliebigen für Wafer üblichen Durchmesser, d, aufweisen (z.B. kann die Trägerplatte 102 ein 150-mm Wafer, ein 200-mm Wafer, ein 300-mm Wafer, ein 450-mm Wafer, etc. sein).
Gemäß verschiedenen Ausführungsformen kann der Träger 100 einen zumindest teilweise auf der Vorderseite, V, der Trägerplatte 102 angeordneten Sensor aufweisen. Im Folgenden wird der Sensor beispielhaft als Schwingquarz beschrieben. Es wird verstanden, dass der Sensor auch jede andere Art von Sensor (z.B. ein Temperatursensor, ein Feuchtigkeitssensor, etc.) sein kann. Es wird ebenfalls verstanden, dass der der Träger 100 mehrere solcher Sensoren aufweisen kann. Diese mehreren Sensoren können die gleiche Art von Sensor aufweisen (z.B. jeweils einen Schwingquarz) oder können voneinander verschiedene Arten von Sensoren aufweisen (z.B. kann der Träger 100 einen Schwingquarz und einen Temperatursensor aufweisen).

Dementsprechend kann der Träger 100 einen zumindest teilweise auf der Vorderseite, V, der Trägerplatte 102 angeordneten Schwingquarz 104 aufweisen. Der Schwingquarz 104 kann eine erste Elektrode und eine zweite Elektrode aufweisen.

Gemäß verschiedenen Ausführungsformen kann der Träger 100 einen ersten Elektrodenkontakt 106 und einen zweiten Elektrodenkontakt 108 zum Kontaktieren des Schwingquarzes 104 aufweisen. Hierbei kann der erste Elektrodenkontakt 106 mit der ersten Elektrode des Schwingquarzes 104 elektrische leitend verbunden sein und der zweite Elektrodenkontakt 108 kann mit der zweiten Elektrode des Schwingquarzes 104 elektrische leitend verbunden sein.

Der erste Elektrodenkontakt 106 und der zweite Elektrodenkontakt 108 können beliebig auf der Trägerplatte 102 angeordnet sein. Gemäß verschiedenen Ausführungsformen können der erste Elektrodenkontakt 106 und der zweite Elektrodenkontakt 108 auf der Rückseite, R, der Trägerplatte 102 angeordnet sein. Es wird verstanden, dass auch mindestens einer dieser Elektrodenkontakte 106, 108 auf der Vorderseite, V, der Trägerplatte 102 angeordnet sein kann. In diesem Fall kann der hierin beschriebene Wafer-Chuck 200 entsprechende Kontakte aufweisen zum Kontaktieren des mindestens einen Elektrodenkontakts auf der Vorderseite, V, der Trägerplatte 102.

Gemäß verschiedenen Ausführungsformen kann der Schwingquarz 104 als Quarzkristall-Mikrowaage eingerichtet sein bzw. als solche verwendet werden.

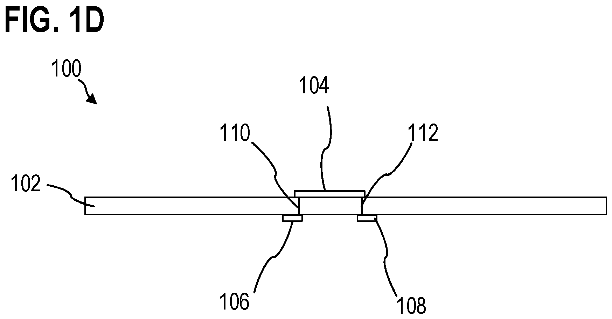

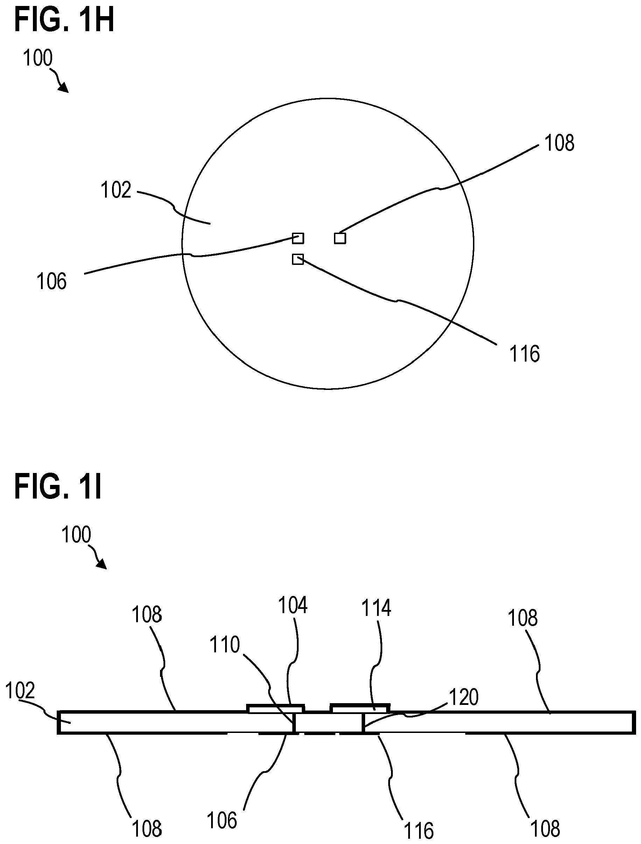

Mit Bezug auf FIG.1D kann der auf der Rückseite, R, der Trägerplatte 102 angeordnete erste Elektrodenkontakt 106 mit der ersten Elektrode des Schwingquarzes 104 beispielsweise mittels mindestens einer in der Trägerplatte 102 ausgebildeten ersten Durchkontaktierung 110 (auch als Via bezeichnet) elektrisch leitend verbunden sein. Der auf der Rückseite, R, der Trägerplatte 102 angeordnete zweite Elektrodenkontakt 108 kann mit der zweiten Elektrode des Schwingquarzes 104 beispielsweise mittels mindestens einer in der Trägerplatte 102 ausgebildeten zweiten Durchkontaktierung 120 elektrisch leitend verbunden sein. Alternativ kann der zweite Elektrodenkontakt 108 mit der zweiten Elektrode des Schwingquarzes 104 mittels einer auf der Oberfläche der Trägerplatte 102 ausgebildeten elektrisch leitenden Schicht verbunden sein (siehe zum Beispiel FIG.1I).

Gemäß verschiedenen Ausführungsformen kann der Träger 100 mehr als einen auf der Vorderseite, V, der Trägerplatte 102 angeordneten Schwingquarz aufweisen. Die mehreren Schwingquarze können an verschiedenen Positionen des Trägers 100 angeordnet sein, so dass während eines Prozessierens eine jeweilige Schichtdicke und/oder Schichtdickenänderung an jeder der verschiedenen Positionen erfasst werden kann.

Ein entsprechendes Beispiel für zwei Schwingquarze ist in **FIG.1E** bis **FIG.1I** gemäß verschiedenen Ausführungsformen gezeigt. Hierbei kann ein anderer Schwingquarz 114 zumindest teilweise auf der Vorderseite, V, der Trägerplatte 102 angeordnet sein. Der andere Schwingquarz 114 kann ähnlich zu dem Schwingquarz 104 eingerichtet sein. So kann der andere Schwingquarz ebenfalls zwei Elektroden (z.B. eine andere erste Elektrode und eine andere zweite Elektrode) aufweisen.

Wie in FIG.1F gezeigt, kann der Träger 100 einen (z.B. auf der Rückseite, R, der Trägerplatte 102 angeordneten) anderen ersten Elektrodenkontakt 116 und einen (z.B. auf der Rückseite, R, der Trägerplatte 102 angeordneten) anderen zweiten Elektrodenkontakt 118 aufweisen. Hierbei kann der andere erste Elektrodenkontakt 116 mittels mindestens einer anderen ersten Durchkontaktierung 120 elektrisch leitend mit der anderen ersten Elektrode des anderen Schwingquarzes 114 verbunden sein. Gemäß manchen Ausführungsformen kann der andere zweite Elektrodenkontakt 118 mittels mindestens einer anderen zweiten Durchkontaktierung elektrisch leitend mit der anderen zweiten Elektrode des anderen Schwingquarzes 114 verbunden sein.

Alternativ, wie in FIG.1H und FIG.1I gezeigt, kann der Träger 100 den (z.B. auf der Rückseite, R, der Trägerplatte 102 angeordneten) anderen ersten Elektrodenkontakt 116, aber nicht den (z.B. auf der Rückseite, R, der Trägerplatte 102 angeordneten) anderen zweiten Elektrodenkontakt 118 aufweisen. In diesem Fall kann der zweite Elektrodenkontakt 108 ein gemeinsamer Elektrodenkontakt des Schwingquarzes 104 und des anderen Schwingquarzes 114 sein. Wie in FIG.1I gezeigt, kann der Träger 100 beispielsweise eine auf der Oberfläche der Trägerplatte 102 angeordnete elektrisch leitende Schicht aufweisen, welche die zweite Elektrode des Schwingquarzes 104 und die andere zweite Elektrode des anderen Schwingquarzes 114 elektrisch leitend mit dem (gemeinsamen) zweiten Elektrodenkontakt 108 verbindet.

Anschaulich kann der hierin beschriebene Träger 100 als ein Messwafer dienen. Mittels dieses Messwafers können beispielsweise verschiedene Prozesse analysiert werden. In anderen Ausgestaltungen kann der Träger 100 ein zu fertigender Wafer sein. Anschaulich können die ein oder mehreren Schwingquarze auf einem zu fertigenden (z.B. in einem Fertigungsschritt) Wafer angeordnet werden, um Prozesse direkt während der Fertigung zu analysieren. In diesem Fall kann zum Beispiel die Fertigung des Wafers derart angepasst werden, dass zuvor entsprechende Rückseitenkontakte (als Elektrodenkontakte 106, 108, 116, 118) und optional entsprechende Durchkontaktierungen vorgesehen werden.

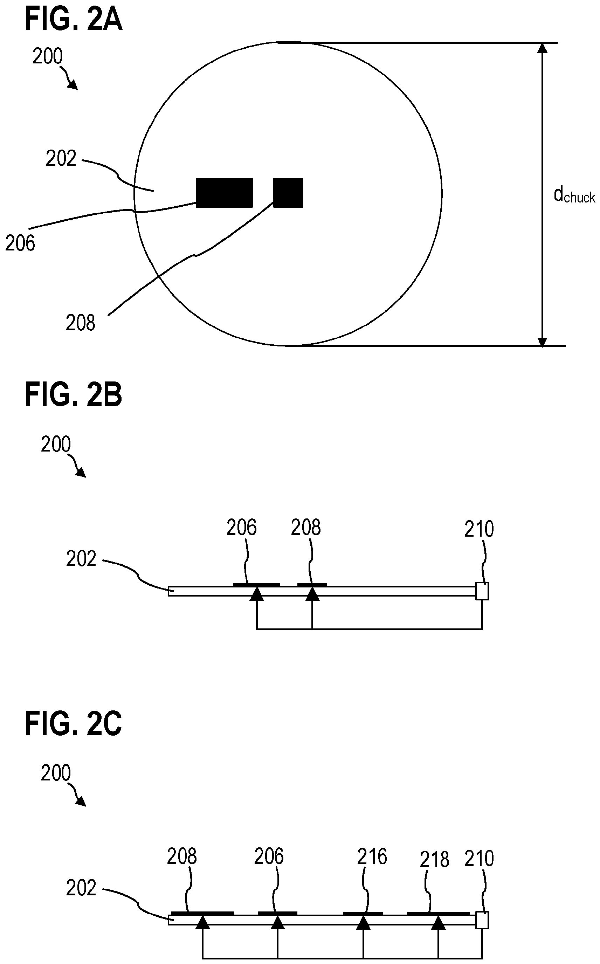

**FIG.2A** und **FIG.2B** zeigen einen Wafer-Chuck 200 gemäß verschiedenen Ausführungsformen. Der Wafer-Chuck 200 kann eine Basisplatte 202 aufweisen. Gemäß verschiedenen Ausführungsformen kann ein herkömmlicher Wafer-Chuck zu dem Wafer-Chuck 200 modifiziert werden. In diesem Fall kann die Basisplatte 202 zum Beispiel der herkömmliche Wafer-Chuck sein.

Die Basisplatte 202 kann eingerichtet sein, einen Träger (z.B. den Träger 100) zu tragen (bzw. zu halten). Der Wafer-Chuck 200 kann jede beliebige Form und Größe haben. Gemäß verschiedenen Ausführungsformen kann der Träger ein Wafer sein, so dass die Basisplatte 202 zum Tragen des Wafers eingerichtet sein kann. In diesem Fall kann die Basisplatte 202 eine Größe (z.B. einen Durchmesser, d_{chuck} ) aufweisen, die gleich oder größer als ein Durchmesser, d, des Wafers (z.B. des Trägers 100) ist.

Der Wafer-Chuck 200 kann mehrere elektrische Kontakte, wie beispielsweise einen ersten elektrischen Kontakt 206 und einen zweiten elektrischen Kontakt 208 aufweisen. Die mehreren elektrischen Kontakte (z.B. der erste elektrische Kontakt 206 und der zweite elektrische Kontakt 208) können auf derselben Seite des Wafer-Chucks 200 angeordnet sein. Diese mehreren elektrischen Kontakte können dem elektrischen Kontaktieren von Rückseitenkontakten des Wafers dienen. Alternativ kann mindestens einer der mehreren elektrischen Kontakte anderweitig angeordnet sein und kann derart eingerichtet sein, dass dieser einen auf der Vorderseite des Wafers angeordneten Vorderseitenkontakt elektrisch leitend kontaktieren kann.

In FIG.2A und FIG.2B sind der erste elektrische Kontakt 206 und der zweite elektrische Kontakt 208 als Kontaktflächen dargestellt. Alternativ kann mindestens einer dieser Kontakte ein Kontaktpin sein.

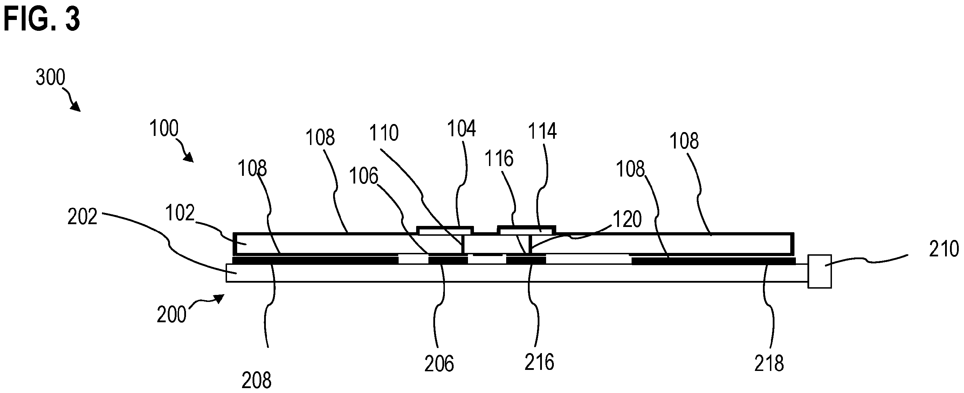

Die mehreren elektrischen Kontakte (z.B. der erste elektrische Kontakt 206 und der zweite elektrische Kontakt 208) können eingerichtet sein zum Bereitstellen eines Signalwegs zu einem auf dem Wafer angeordneten Sensor (z.B. Schwingquarz 104), wenn der Wafer von der Basisplatte getragen/gehalten wird (siehe z.B. Beschreibung bezüglich FIG.3) .

Gemäß verschiedenen Ausführungsformen kann der Wafer-Chuck 200 eine Schnittstelle 210 aufweisen. Die Schnittstelle 210 kann mit den mehreren elektrischen Kontakten (z.B. dem ersten elektrischen Kontakt 206 und dem zweiten elektrischen Kontakt 208) elektrisch leitend verbunden sein. Die Schnittstelle 210 kann derart eingerichtet sein, dass mittels der Schnittstelle 210 ein elektrisches Signal an die mehreren elektrischen Kontakte angelegt und/oder abgegriffen werden kann.

Gemäß verschiedenen Ausführungsformen kann mindestens ein elektrischer Kontakt der mehreren elektrischen Kontakte derart angeordnet sein, dass dieser in einem Abstand zu dem Wafer angeordnet ist, wenn der Wafer von der Basisplatte 202 getragen wird.

**FIG.2C** zeigt den Wafer-Chuck 200 gemäß verschiedenen Ausführungsformen. Hier können die mehreren elektrischen Kontakte zusätzlich zu dem ersten elektrischen Kontakt 206 und dem zweiten elektrischen Kontakt 208 einen anderen ersten elektrischen Kontakt 216 und einen anderen zweiten elektrischen Kontakt 218 aufweisen. Diese können entsprechend mit der Schnittstelle 210 zum Anlegen eines entsprechenden anderen elektrischen Sensorsignals gekoppelt sein.

Zum Beispiel kann mittels dem anderen ersten elektrischen Kontakt 216 und dem anderen zweiten elektrischen Kontakt 218 der andere Schwingquarz 114 des Trägers 100 elektrisch kontaktiert werden, wenn der Träger 100 auf dem Wafer-Chuck 200 angeordnet wird. In dem Fall, dass der zweite Elektrodenkontakt 108 des Trägers 100 der gemeinsame Elektrodenkontakt des Schwingquarzes 104 und des anderen Schwingquarzes 114 ist, kann an dem ersten elektrischen Kontakt 208 und dem anderen ersten elektrischen Kontakt 218 des Wafer-Chucks 200 ein gemeinsames Potential (z.B. ein Massepotential) anliegen.

Wie hierin beschrieben, können der Träger 100 und der Wafer-Chuck 200 aufeinander abgestimmt sein, so dass der Träger 100 auf dem Wafer-Chuck 200 angeordnet und entsprechend kontaktiert werden kann.

**FIG.3** zeigt ein System 300, bei dem der Träger 100 auf dem Wafer-Chuck 200 angeordnet ist, gemäß verschiedenen Ausführungsformen. FIG.3 zeigt eine beispielhafte Ausgestaltung für zwei Schwingquarze. Es wird verstanden, dass die nachfolgenden Ausführungen entsprechend für weniger (also einen Schwingquarz) und für mehr als zwei Schwingquarze gelten.

Gemäß verschiedenen Ausführungsformen können der Träger 100 und der Wafer-Chuck 200 derart eingerichtet sein, dass, wenn der Träger 100 auf dem Wafer-Chuck 200 angeordnet ist:
- der erste Elektrodenkontakt 106 des Trägers 100 mit dem ersten elektrischen Kontakt 206 des Wafer-Chucks 200 koppelt,
- der (in diesem Beispiel gemeinsame) zweite Elektrodenkontakt 108 des Trägers mit dem zweiten elektrischen Kontakt 208 (und optional ferner mit dem anderen zweiten elektrischen Kontakt 218) des Wafer-Chucks 200 koppelt, und
- der andere erste Elektrodenkontakt 116 des Trägers 100 mit dem anderen ersten elektrischen Kontakt 216 des Wafer-Chucks 200 koppelt.

Ein Koppeln zwischen elektrischen Kontakten, wie hierin beschrieben, kann durch einen direkten physischen Kontakt der elektrischen Kontakte erfolgen. Alternativ kann gemäß verschiedenen Ausführungsformen ein Spalt zwischen den elektrischen Kontakten verbleiben.

In verschiedenen Ausführungsformen sind der Träger 100 und/oder der Wafer-Chuck 200 derart eingerichtet, dass der Spalt zwischen zwei gekoppelten Kontakten vorliegt. Hierdurch kann beispielsweise ein Verschleiß signifikant verringert und/oder ein Gleichstromkontakt blockiert werden.

Mittels der Schnittstelle 210 kann über die gekoppelten Kontakte ein jeweiliges Sensorsignal an den Schwingquarz 104 und den anderen Schwingquarz 114 angelegt werden. Die Schichtdickenänderung kann hierbei auf herkömmliche Art und Weise mittels des Schwingquarzes 104 und/oder des anderen Schwingquarzes 114 ermittelt werden. So führt das Abscheiden einer Schicht auf dem jeweiligen Schwingquarz und das Entfernen einer auf dem Schwingquarz abgeschiedenen Schicht zu einer Änderung der Frequenz des Schwingquarzes. Diese Frequenzänderung kann erfasst werden und daraus kann die Schichtdickenänderung (und damit eine Schichtdicke) ermittelt werden. Diese Frequenzänderung kann (z.B. kontinuierlich) während der Schichtabscheidung bzw. des Entfernens (z.B. Ätzens) erfasst werden und/oder kann nach dem jeweiligen Prozess erfasst werden. Gemäß verschiedenen Ausführungsformen kann eine frequenzabhängige Impedanz des jeweiligen Schwingquarzes erfasst (z.B. gemessen) werden. Die frequenzabhängige Impedanz des Schwingquarzes ist hierbei von der prozessbedingten Frequenzänderung abhängig, so dass die Schichtdickenänderung anhand des frequenzabhängigen Impedanzverlaufes ermittelt werden kann. Gemäß verschiedenen Ausführungsformen kann das Anlegen des Sensorsignals an den Schwingquarz 104 einen Schwingkreis erzeugen. Wird hierin von der Resonanzfrequenz des Schwingquarzes gesprochen, so wird verstanden, dass sich diese Resonanzfrequenz erst in dem Schwingkreis (also nach Anlegen des Sensorsignals) ausbildet. Gemäß verschiedenen Ausführungsformen kann während des Abscheidens der Schicht (z.B. kontinuierlich) eine Resonanzfrequenz des mittels des Anlegens des Sensorsignals erzeugten Schwingkreises gemessen werden. Die Resonanzfrequenz kann zum Beispiel mit einer minimalen Impedanz (bei einem Reihenschwingkreis) oder einer maximalen Impedanz (bei einem Parallelschwingkreis) erfasst werden.

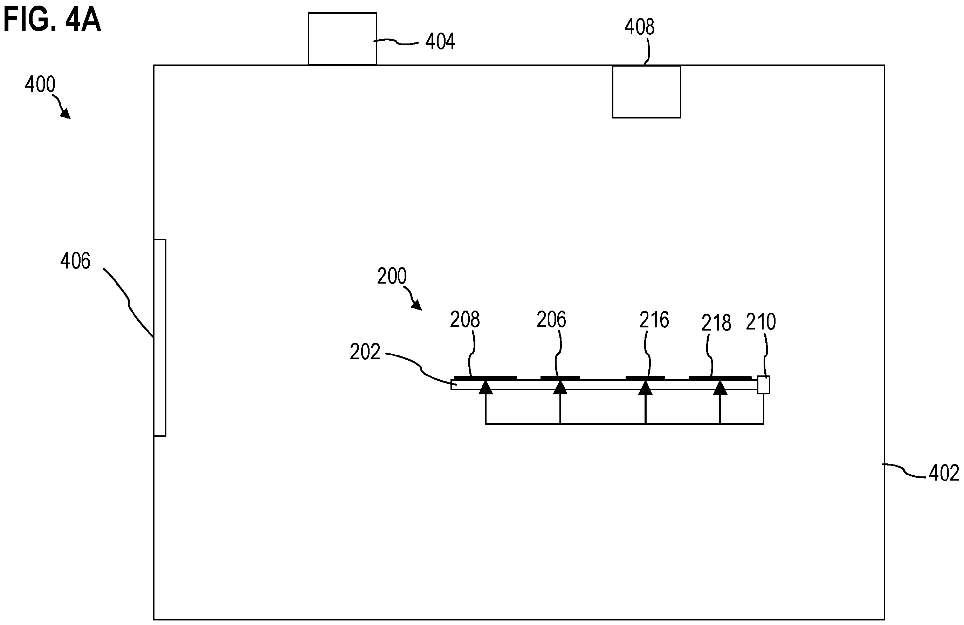

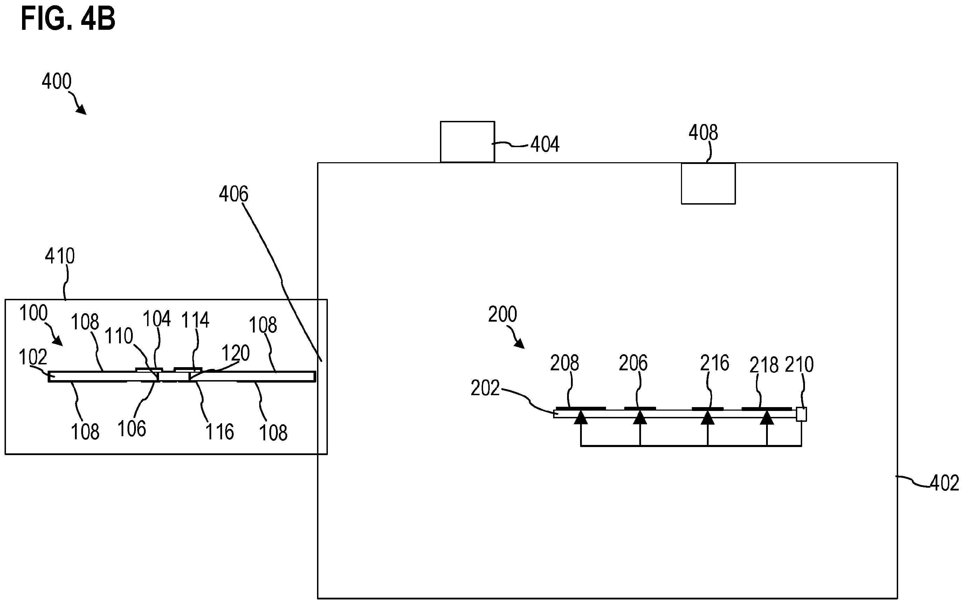

FIG.4A zeigt eine Prozessiervorrichtung 400 gemäß verschiedenen Ausführungsformen. Die Prozessiervorrichtung 400 kann eine Prozesskammer 402 aufweisen. So kann die Prozesskammer 402 beispielsweise (z.B. mittels einer entsprechenden Öffnung (z.B. einem Flansch)) mit einem Pumpensystem 404 zum Erzeugen eines Unterdrucks (z.B. Vakuums) in der Prozesskammer 402 gekoppelt sein. Das Pumpensystem 404 kann ein oder mehrere Vakuumpumpen aufweisen. Eine Vakuumpumpe kann jede Art von Vakuumpumpe sein, wie beispielsweise eine Hochvakuumpumpe (z.B. eine Turbomolekularpumpe) oder eine Vorpumpe (z.B. eine Scrollpumpe, eine Membranpumpe oder eine (z.B. mehrstufige) Wälzkolbenpumpe, eine Diffusionspumpe, Drehschieberpumpe) Das Pumpensystem 404 kann eine Kombination aus einem oder mehreren der obigen Pumpen sein. Zum Beispiel kann das Pumpensystem 404 einen aus Vorpumpe und Turbomolekularpumpe kombinierten Pumpstand aufweisen. Es wird verstanden, dass die Prozesskammer 402 zum Erreichen/Halten des Unterdrucks, wenn verschlossen, beispielsweise luftdicht, staubdicht und/oder vakuumdicht eingerichtet sein kann.

Der Unterdruck in der Prozesskammer 402 kann ein Druck (der z.B. der Außendruck ist) in einem Bereich von ungefähr 10 mbar bis ungefähr 1 mbar (mit anderen Worten Grobvakuum) oder weniger sein, beispielsweise ein Druck in einem Bereich von ungefähr 1 mbar bis ungefähr 10⁻³ mbar (mit anderen Worten Feinvakuum) oder weniger, beispielsweise ein Druck in einem Bereich von ungefähr 10⁻³ mbar bis ungefähr 10⁻⁷ mbar (mit anderen Worten Hochvakuum) oder weniger, beispielsweise ein Druck in einem Bereich kleiner 10⁻⁷ mbar (mit anderen Worten Ultra-Hochvakuum).

Die Prozesskammer 402 kann mindestens eine Schleus-Schnittstelle 406 zum Einschleusen und/oder Ausschleusen des Trägers 100 aufweisen. Hierbei kann der Träger 100 vor dem Einschleusen bzw. nach dem Ausschleusen in einem mittels der Schleus-Schnittstelle 406 benachbarten Element 410 angeordnet sein. Wie hierin beschrieben, kann der Aufbau der Prozesskammer 402 beim Einschleusen und/oder Ausschleusen des Trägers 100 unverändert bleiben.

In manchen Ausführungsformen kann das Element 410 eine Vorkammer sein. Diese Vorkammer kann auch mit einem entsprechenden Pumpensystem zum Erzeugen eines Unterdrucks gekoppelt sein. In diesem Fall kann die Vorkammer mittels eines Schiebers (kann auch als Schieberventil oder Tor (engl.: Gate) bezeichnet werden) an der Schleus-Schnittstelle 406 von der Prozesskammer 402 vakuumgetrennt sein. Der Träger kann in der Vorkammer angeordnet werden, ein Unterdruck kann in der Vorkammer erzeugt werden (das Erzeugen eines Unterdrucks in einer Kammer kann auch als Evakuieren der Kammer bezeichnet werden), der Schieber kann geöffnet werden und der Träger kann in die Prozesskammer 402 (z.B. auf den in der Prozesskammer 402 angeordneten Wafer-Chuck 200) transferiert werden. Es wird verstanden, dass beim Transferieren des Trägers 100 ein oder mehrere Probenhalter und/oder ein oder mehrere Manipulatoren verwendet werden können.

In anderen Ausführungsformen kann das Element 410 ein einheitlicher Frontöffnungs-Behälter (engl.: Front Opening Unified Pod, kurz FOUP) sein. Dieser kann initial, wie für die Vorkammer beschrieben, mittels eines Schiebers vakuumentkoppelt sein und nach einem Anordnen des FOUP an der Schleus-Schnittstelle 406 kann der Schieber geöffnet und der Träger 100 von dem FOUP in die Prozesskammer 402 eingeschleust bzw. aus der Prozesskammer 402 in den FOUP ausgeschleust werden. Obgleich hierin zur Veranschaulichung beschrieben wird, dass ein FOUP an der Schleus-Schnittstelle 406 der Prozesskammer 402 angeordnet werden kann, wird verstanden, dass der FOUP auch entsprechend an einer Schleus-Schnittstelle einer mit der Prozesskammer 402 verbundenen (z.B. vakuumgekoppelten) Vorkammer oder einer anderen mit der Prozesskammer 402 verbundenen (z.B. vakuumgekoppelten) Kammer angeordnet werden kann.

In noch anderen Ausführungsformen kann das Element 410 eine benachbarte Prozesskammer sein. In diesem Fall kann der Träger 100 nacheinander durch die Prozesskammer und die benachbarte Prozesskammer (in beliebiger Reihenfolge) geführt (z.B. transportiert) werden. Zum Beispiel kann die Prozessiervorrichtung 400 eine Transportvorrichtung (z.B. mit einem Transportband und/oder Transportrollen) aufweisen zum Transportieren des auf dem Wafer-Chuck 200 angeordneten Trägers 100 durch die Prozesskammer und die benachbarte Prozesskammer hindurch. Anschaulich kann hierbei auch der Wafer-Chuck 200 bewegt werden, um die beispielsweise mit Bezug auf FIG.3 beschriebenen Messungen in jeder der Prozesskammern durchzuführen.

Es wird verstanden, dass die Prozesskammer 402 alternativ auch geöffnet werden kann und der Träger anschließend auf den Wafer-Chuck 200 angeordnet (z.B. auf diesen gelegt) werden kann. In diesem Fall kann die Prozesskammer 402 nach dem Anordnen des Trägers 100 auf dem Wafer-Chuck 200 evakuiert werden.

Die Prozessiervorrichtung 400 kann eine (z.B. in der Prozesskammer 402 angeordnet und/oder mit der Prozesskammer 402 gekoppelte) Beschichtungsvorrichtung 408 aufweisen. Die Beschichtungsvorrichtung 408 kann derart eingerichtet sein, dass eine Schicht auf der Vorderseite des auf dem Wafer-Chuck 200 angeordneten Trägers 100 (z.B. Wafers) abgeschieden werden kann. Folglich kann die Beschichtungsvorrichtung 408 derart eingerichtet sein, dass mittels der Beschichtungsvorrichtung 408 ein Beschichtungsverfahren in der Prozesskammer 402 durchgeführt werden kann. Das Beschichtungsverfahren kann beispielsweise ein physikalisches Gasphasenabscheidungsverfahren (PVD-Verfahren) oder ein chemisches Gasphasenabscheidungsverfahren (CVD-Verfahren) sein. Das PVD-Verfahren kann zum Beispiel eine Elektronenstrahlverdampfung, eine Kathodenzerstäubung, oder Ähnliches sein. Das CVD-Verfahren kann zum Beispiel eine Atomlagenabscheidung (engl. atomic layer deposition, kurz ALD) sein. Es wird verstanden, dass eine Atomlagenabscheidung als ein CVD-Verfahren betrachtet werden kann. Wird hierin von einem CVD-Verfahren gesprochen, so kann dieses beispielsweise ALD sein. Wie hierin beschrieben, ist der Träger 100 (und der Wafer-Chuck 200) besonders vorteilhaft für CVD-Verfahren, da bei diesen üblicherweise keine in situ Messungen der Schichtdicke und/oder Schichtdickenänderung durchgeführt werden können.

Optional kann die Frequenz des Schwingquarzes 104 und/oder des anderen Schwingquarzes 114 (z.B. zusätzlich) ex situ nach der Schichtabscheidung (und/oder nach dem Ätzen) erfasst werden.

Es wird verstanden, dass entsprechend dem jeweiligen PVD- oder CDV-Verfahren während des Beschichtungsverfahrens Materialien, Reaktanden oder Prozessgase in die Prozesskammer 402 zugeführt werden können und/oder dass eine Temperatur des Trägers 100 verändert (z.B. erhöht) wird. So kann beispielsweise ein CVD-Verfahren bei erhöhten Temperaturen (z.B. 100°C, 200°C, 300°C, etc.) durchgeführt werden. Das Prozessgas kann ein Inertgas, wie beispielsweise Argon, und/oder ein Reaktivgas, wie beispielsweise Sauerstoff, aufweisen.

Wie hierin beschrieben, kann mittels des auf dem Wafer-Chuck 200 angeordneten Trägers 100 eine Schichtdicke einer mittels des Beschichtungsverfahrens abgeschiedenen Schicht und/oder eine Schichtabscheidungsrate während des Beschichtungsverfahrens ermittelt werden.

Gemäß verschiedenen Ausführungsformen kann der auf dem Wafer-Chuck 200 angeordnete Träger 100 von der Prozesskammer 402 in die benachbarte Prozesskammer transportiert werden. Die benachbarte Prozesskammer kann ebenfalls eine Beschichtungsvorrichtung zum Durchführen eines Beschichtungsverfahrens aufweisen und die dem Beschichtungsverfahren zugehörige Schichtdicke und/oder Schichtabscheidungsrate kann ermittelt werden. Zusätzlich oder alternativ kann die andere Prozesskammer eine Entfernvorrichtung zum zumindest teilweisen Entfernen (z.B. Ätzen) der in der abgeschiedenen Schicht aufweisen. Wie für das Beschichtungsverfahren beschrieben, kann eine während und/oder nach dem Entfernen verbleibende Schichtdicke ermittelt werden. Auch kann während des Entfernens eine Schichtdickenänderungsrate (z.B. eine Ätzrate) ermittelt werden.

Zusätzlich oder alternativ kann der Träger 100 nach dem Ausschleusen aus der Prozesskammer 402 in einer noch anderen Prozesskammer zusätzlich beschichtet werden und/oder eine zuvor abgeschiedene Schicht kann /z.B. mittels eines Ätzverfahrens) zumindest teilweise entfernt werden. Wie voranstehend beschrieben kann auch hier wiederum eine Schichtdicke und/oder eine Schichtdickenänderung ermittelt werden. Anschaulich zeigt sich dadurch die Wiederverwendbarkeit des hierin beschriebenen Trägers 100.

Gemäß verschiedenen Ausführungsformen kann die Prozessiervorrichtung 400 eine Steuervorrichtung aufweisen. Die Steuervorrichtung kann eingerichtet sein, das Ein- und Ausschleusen, das Anlegen des Sensorsignals zum Erzeugen des Schwingkreises, und/oder das Erfassen der Resonanzfrequenz zu steuern. Die Steuervorrichtung kann eingerichtet sein, die erfasste Resonanzfrequenz an eine Auswerteeinheit direkt oder indirekt (z.B. mittels ein oder mehrerer Speichermedien) bereitzustellen.

Wie hierin beschrieben, ist der Schwingquarz 104 ein Beispiel für einen Sensor und der Träger 100 kann zusätzlich oder alternativ jede Art von Sensor aufweisen. In diesem Fall können entsprechende Parameter mittels des Sensors direkt auf dem Träger 100 in der Prozesskammer 402 erfasst werden. Zum Beispiel kann der Sensor ein Temperatursensor sein zum Erfassen einer Temperatur des Trägers 100. Eine Änderung der Temperatur des Trägers 100 kann verschiedene Ursachen haben. Zum Beispiel kann das Beschichtungsverfahren ein PVD-Verfahren sein, bei welchem Wärmestrahlung abgegeben wird. Zum Beispiel kann die Prozessiervorrichtung 400 eine Temperiervorrichtung aufweisen, welche eingerichtet sein kann, eine Temperatur des Trägers 100 zu erhöhen (also Heizen) oder zu verringern (also Kühlen). Zum Beispiel kann das Beschichtungsverfahren ein CVD-Verfahren sein, bei welchem die Temperatur des Trägers 100 mittels der Temperiervorrichtung erhöht wird.

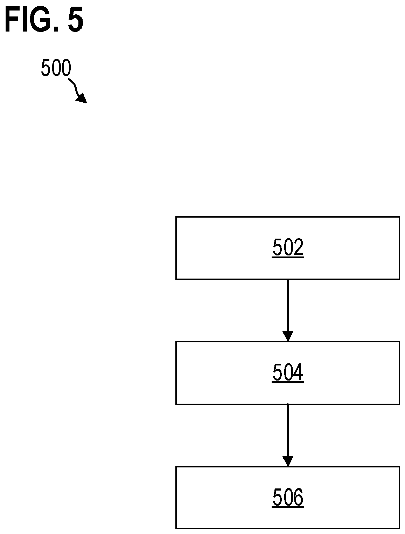

**FIG.5** zeigt ein Ablaufdiagramm eines Verfahrens 500 gemäß verschiedenen Ausführungsformen.

Das Verfahren 500 kann ein Einschleusen eines Trägers (z.B. eines Wafers) in eine Prozesskammer aufweisen (in 502). Der Träger kann eine Trägerplatte, einen auf der Vorderseite der Trägerplatte angeordneten Schwingquarz, und einen ersten Elektrodenkontakt und einen zweiten Elektrodenkontakt zum Kontaktieren des Schwingquarzes aufweisen. Zum Beispiel kann der Träger gemäß dem Träger 100 eingerichtet sein. Bei diesem Einschleusen kann der Aufbau der Prozesskammer unverändert bleiben. Gemäß verschiedenen Ausführungsformen kann das Einschleusen des Trägers ein Transferieren des Trägers aus einem (z.B. mit der Prozesskammer direkt oder durch Zwischenkammern gekoppelten) einheitlichen Frontöffnungs-Behälter (Front Opening Unified Pod, FOUP) in die Prozesskammer aufweisen. Alternativ kann das Einschleusen des Trägers ein Einschleusen mittels einer Vorkammer aufweisen. Das Einschleusen mittels einer Vorkammer kann beispielsweise aufweisen: Anordnen des Trägers in einer mit der Prozesskammer gekoppelten Vorkammer, Evakuieren der Vorkammer, Öffnen eines Schiebers (engl.: Gate) zwischen der Vorkammer und der Prozesskammer, und Transferieren des Trägers von der Vorkammer in die Prozesskammer.

Das Verfahren 500 kann ein Koppeln (z.B. in Kontakt bringen) des ersten Elektrodenkontaktes und des zweiten Elektrodenkontaktes mit einer in der Prozesskammer angeordneten Schnittstelle aufweisen (in 504). Die Schnittstelle kann zum Beispiel eine Schnittstelle eines in der Prozesskammer angeordneten Wafer-Chucks (z.B. die Schnittstelle 210 des Wafer-Chucks 200) sein.

Das Verfahren 500 kann ein Anlegen eines Sensorsignals an den Schwingquarz mittels der Schnittstelle (in 506). Gemäß verschiedenen Ausführungsformen kann während des Anlegens des Sensorsignals ein Messsignal erfasst werden. Das Messsignal kann zum Beispiel eine Impedanz des Schwingquarzes sein.

Optional kann das Verfahren 500 ferner ein Abscheiden einer Schicht (z.B. mittels chemischer Gasphasenabscheidung (CVD) und/oder mittels physikalischer Gasphasenabscheidung (PVD)) auf dem in der Prozesskammer angeordneten Träger aufweisen. Gemäß verschiedenen Ausführungsformen kann das Sensorsignal während des Abscheidens der Schicht an den Schwingquarz angelegt werden. Dadurch kann beispielsweise die Änderung der Schichtdicke während des Abscheidens überwacht werden. Auch kann so eine Schichtdickenänderung erfasst werden. Zusätzlich oder alternativ kann das Sensorsignal nach dem Abscheiden der Schicht an den Schwingquarz angelegt werden. Dadurch kann beispielsweise die Schichtdicke der abgeschiedenen Schicht ermittelt werden.

Durch das Erfassen der Schichtdicke und/oder Schichtdickenänderung direkt auf dem Träger (z.B. Wafer) kann die Messgenauigkeit signifikant erhöht werden.

Optional kann das Verfahren 500 ferner ein Ausschleusen des Trägers aus der Prozesskammer und ein Einschleusen in eine andere Prozesskammer aufweisen. In der anderen Prozesskammer können der erste Elektrodenkontakt und der zweite Elektrodenkontakt des Trägers entsprechend mit einer anderen Schnittstelle gekoppelt werden, mittels welcher wiederum ein Sensorsignal angelegt werden kann. In dieser anderen Prozesskammer kann nun eine andere Schicht abgeschieden und die Schichtdicke bzw. Schichtabscheidungsrate erfasst werden und/oder die Schicht kann (zumindest) teilweise entfernt werden (z.B. mittels Ätzens) und die nach dem Entfernen verbliebene Schichtdicke bzw. die Entfernrate (z.B. Ätzrate) können erfasst werden.

Anschaulich kann mittels des Verfahrens 500 eine fortlaufende Prozesskette beim Prozessieren eines Wafers mittels desselben Sensors bzw. derselben Sensoren überwacht und/oder analysiert werden.

Es wird verstanden, dass Aspekte die mit Bezug auf den Träger 100 und/oder den Wafer-Chuck 200 beschrieben werden auch als Verfahren ausgeführt werden können und vice versa.

Im Folgenden werden Bespiele beschrieben, welche verschiedene Aspekte des Verfahrens, des Trägers und des Wafer-Chucks veranschaulichen.

Beispiel 1 ist ein Verfahren aufweisend: Einschleusen eines Trägers (z.B. eines Wafers) in eine Prozesskammer, wobei der Träger aufweist: eine Trägerplatte, einen auf der Vorderseite der Trägerplatte angeordneten Sensor (z.B. Schwingquarz), und einen ersten Elektrodenkontakt und einen zweiten Elektrodenkontakt zum Kontaktieren des Sensors (z.B. des Schwingquarzes); Koppeln (z.B. in Kontakt bringen) des ersten Elektrodenkontaktes und des zweiten Elektrodenkontaktes mit einer in der Prozesskammer angeordneten Schnittstelle; und Anlegen eines Sensorsignals an den Sensor (z.B. an den Schwingquarz) mittels der Schnittstelle.

Beispiel 2 ist eingerichtet gemäß Beispiel 1, wobei der Aufbau der Prozesskammer beim Einschleusen des Trägers in die Prozesskammer nicht verändert wird.

Beispiel 3 ist ein Verfahren gemäß Beispiel 1 oder 2, wobei das Einschleusen des Trägers in die Prozesskammer aufweist: Anordnen des Trägers in einer mit der Prozesskammer gekoppelten Vorkammer; Evakuieren der Vorkammer; Öffnen eines Schiebers zwischen der Vorkammer und der Prozesskammer; und Transferieren des Trägers von der Vorkammer in die Prozesskammer.

Beispiel 4 ist eingerichtet gemäß Beispiel 1 oder 2, wobei das Einschleusen des Trägers in die Prozesskammer aufweist: Transferieren des Trägers aus einem (z.B. mit der Prozesskammer gekoppelten) einheitlichen Frontöffnungs-Behälter (Front Opening Unified Pod, FOUP) in die Prozesskammer.

Beispiel 5 ist ein Verfahren gemäß einem der Beispiele 1 bis 4, wobei die Schnittstelle an, auf, oder in einem Wafer-Chuck innerhalb der Prozesskammer angeordnet ist oder Teil des Wafer-Chucks ist; und wobei der erste Elektrodenkontakt und der zweite Elektrodenkontakt durch Anordnen (z.B. Auflegen) des Trägers auf dem Wafer-Chuck mit der Schnittstelle gekoppelt werden.

In Beispiel 6 kann das Verfahren gemäß einem der Beispiele 1 bis 5 optional ferner aufweisen: Abscheiden einer Schicht (z.B. mittels chemischer Gasphasenabscheidung (CVD/ALD) und/oder mittels physikalischer Gasphasenabscheidung (PVD)) auf dem in der Prozesskammer angeordneten Träger.

In Beispiel 7 kann das Verfahren gemäß Beispiel 6 optional ferner aufweisen, dass der Sensor ein Schwingquarz ist und das Verfahren kann ferner aufweisen: während des Anlegens des Sensorsignals an den Schwingquarz, Messen einer Resonanzfrequenz eines durch das Anlegen des Sensorsignals erzeugten Schwingkreises. Zusätzlich oder alternativ kann eine frequenzabhängige Impedanz gemessen werden.

In Beispiel 8 kann das Verfahren gemäß Beispiel 7 optional ferner aufweisen: Ermitteln einer Schichtdicke der abgeschiedenen Schicht unter Verwendung der gemessenen Resonanzfrequenz des Schwingquarzes.

Beispiel 9 ist eingerichtet gemäß Beispiel 7 oder 8, wobei die Resonanzfrequenz des Schwingquarzes während des Abscheidens der Schicht gemessen wird und wobei das Verfahren ferner aufweist: Ermitteln einer Schichtabscheidungsrate während des Abscheidens der Schicht unter Verwendung der gemessenen Resonanzfrequenz des Schwingquarzes.

Beispiel 10 ist eingerichtet gemäß einem der Beispiele 6 bis 9, wobei die Schicht mittels chemischer Gasphasenabscheidung (CVD), wie beispielsweise einer Atomlagenabscheidung (ALD), abgeschieden wird.

Beispiel 11 ist ein Verfahren gemäß einem der Beispiele 6 bis 10, ferner aufweisend: nach dem Abscheiden der Schicht, Ausschleusen des Trägers (z.B. des Wafers) aus der Prozesskammer.

Beispiel 12 ist eingerichtet gemäß Beispiel 11, wobei das Ausschleusen des Trägers aus der Prozesskammer aufweist: Transferieren des Trägers aus der Prozesskammer in einen (z.B. den) einheitlichen Frontöffnungs-Behälter (Front Opening Unified Pod, FOUP).

Beispiel 13 ist ein Verfahren gemäß Beispiel 11 oder 12, ferner aufweisend: Einschleusen des Trägers (z.B. des Wafers) in eine andere Prozesskammer; Koppeln (z.B. in Kontakt bringen) des ersten Elektrodenkontaktes und des zweiten Elektrodenkontaktes mit einer in der anderen Prozesskammer angeordneten anderen Schnittstelle; und Anlegen eines anderen Sensorsignals an den Sensor (z.B. an den Schwingquarz) mittels der anderen Schnittstelle.

In Beispiel 14 kann das Verfahren gemäß Beispiel 13 optional ferner aufweisen: zumindest teilweises Entfernen (z.B. Ätzen) der Schicht, wobei das andere Sensorsignal während des Entfernens (z.B. Ätzens) der Schicht an den Schwingquarz angelegt wird; und während des Anlegens des Sensorsignals an den als Schwingquarz eingerichteten Sensor, Messen einer Resonanzfrequenz des Schwingquarzes.

Beispiel 15 ist eingerichtet gemäß Beispiel 14, wobei die Schicht nur teilweise entfernt wird und wobei das Verfahren ferner aufweist: Ermitteln einer Schichtdicke der Schicht nach dem teilweisen Entfernen der Schicht unter Verwendung der gemessenen Resonanzfrequenz des Schwingquarzes.

Beispiel 16 ist eingerichtet gemäß Beispiel 14 oder 15, wobei die Resonanzfrequenz des Schwingquarzes während des Entfernens (z.B. Ätzens) der Schicht gemessen wird und wobei das Verfahren ferner aufweist: Ermitteln einer Entfernrate (z.B. Ätzrate) während des Entfernens der Schicht unter Verwendung der gemessenen Resonanzfrequenz des Schwingquarzes.

Beispiel 17 ist ein Träger, aufweisend: eine Trägerplatte (z.B. einen Wafer) mit einer ersten Seite und einer der ersten Seite gegenüberliegenden zweiten Seite; einen Schwingquarz mit einer ersten Elektrode und einer zweiten Elektrode, wobei der Schwingquarz zumindest teilweise auf der ersten Seite der Trägerplatte angeordnet ist; und einen ersten Elektrodenkontakt und einen zweiten Elektrodenkontakt auf der zweiten Seite der Trägerplatte, wobei der erste Elektrodenkontakt mit der ersten Elektrode des Schwingquarzes elektrische leitend verbunden ist und wobei der zweite Elektrodenkontakt mit der zweiten Elektrode des Schwingquarzes elektrische leitend verbunden ist.

Beispiel 18 ist eingerichtet gemäß Beispiel 17, wobei der Schwingquarz in Verbindung mit dem ersten Elektrodenkontakt und dem zweiten Elektrodenkontakt als Quarzkristall-Mikrowaage eingerichtet ist.

In Beispiel 19 kann der Träger gemäß Beispiel 17 oder 18 optional ferner aufweisen: mindestens eine erste Durchkontaktierung, welche in der Trägerplatte ausgebildet ist und die erste Elektrode des Schwingquarzes mit dem ersten Elektrodenkontakt elektrisch leitend verbindet.

In Beispiel 20 kann der Träger gemäß einem der Beispiele 17 bis 19 optional ferner aufweisen: mindestens eine zweite Durchkontaktierung, welche in der Trägerplatte ausgebildet ist und die zweite Elektrode des Schwingquarzes mit dem zweiten Elektrodenkontakt elektrisch leitend verbindet.

Beispiel 21 ist eingerichtet gemäß einem der Beispiele 17 bis 18, wobei die Trägerplatte die zweite Elektrode des Schwingquarzes mit dem zweiten Elektrodenkontakt elektrisch leitend verbindet.

In Beispiel 22 kann der Träger gemäß einem der Beispiele 17 bis 21 optional ferner aufweisen: einen anderen Schwingquarz mit einer anderen ersten Elektrode und einer anderen zweiten Elektrode, wobei der andere Schwingquarz zumindest teilweise auf der ersten Seite der Trägerplatte angeordnet ist; und einen anderen ersten Elektrodenkontakt und einen anderen zweiten Elektrodenkontakt auf der zweiten Seite der Trägerplatte, wobei der andere erste Elektrodenkontakt mit der andere ersten Elektrode des andere Schwingquarzes elektrische leitend verbunden ist und wobei der andere zweite Elektrodenkontakt mit der anderen zweiten Elektrode des anderen Schwingquarzes elektrische leitend verbunden ist.

In Beispiel 23 kann der Träger gemäß Beispiel 22 optional ferner aufweisen: mindestens eine andere erste Durchkontaktierung, welche in der Trägerplatte ausgebildet ist und die andere erste Elektrode des anderen Schwingquarzes mit dem anderen ersten Elektrodenkontakt elektrisch leitend verbindet; und mindestens eine andere zweite Durchkontaktierung, welche in der Trägerplatte ausgebildet ist und die andere zweite Elektrode des anderen Schwingquarzes mit dem anderen zweiten Elektrodenkontakt elektrisch leitend verbindet.

In Beispiel 24 kann der Träger gemäß einem der Beispiele 17 bis 21 optional ferner aufweisen: einen anderen Schwingquarz mit einer anderen ersten Elektrode und einer anderen zweiten Elektrode, wobei der andere Schwingquarz zumindest teilweise auf der ersten Seite der Trägerplatte angeordnet ist; und einen anderen Elektrodenkontakt auf der zweiten Seite der Trägerplatte, wobei der andere Elektrodenkontakt mit der andere ersten Elektrode des andere Schwingquarzes elektrische leitend verbunden ist und wobei die andere zweite Elektrode des anderen Schwingquarzes elektrische leitend mit dem zweiten Elektrodenkontakt verbunden ist.

In Beispiel 25 kann der Träger gemäß Beispiel 24 optional ferner aufweisen: mindestens eine andere Durchkontaktierung, welche in der Trägerplatte ausgebildet ist und die andere erste Elektrode des anderen Schwingquarzes mit dem anderen Elektrodenkontakt elektrisch leitend verbindet; und wobei die Trägerplatte die andere zweite Elektrode des anderen Schwingquarzes mit dem zweiten Elektrodenkontakt elektrisch leitend verbindet.

Beispiel 26 ist ein Wafer-Chuck, aufweisend: eine Basisplatte zum Tragen/Halten eines Wafers; mehrere elektrische Kontakte (z.B. als Kontaktfläche oder als Kontaktpin) zum Bereitstellen eines Signalwegs zu einem auf dem Wafer angeordneten Sensor (z.B. zu einem Schwingquarz), wenn der Wafer von der Basisplatte getragen/gehalten wird; eine mit den mehreren elektrischen Kontakten elektrisch leitend verbundene Schnittstelle, welche derart eingerichtet ist, dass mittels der Schnittstelle ein elektrisches Sensorsignal an die mehreren elektrischen Kontakte angelegt werden kann.

Beispiel 27 ist eingerichtet gemäß Beispiel 26, wobei mindestens ein elektrischer Kontakt der mehreren elektrischen Kontakte derart angeordnet ist, dass dieser, wenn ein Wafer von der Basisplatte getragen/gehalten wird, in einem Abstand zu dem Wafer angeordnet ist.

Beispiel 28 ist eingerichtet gemäß Beispiel 26 oder 27, wobei der Sensor eine Quarzkristall-Mikrowaage ist.

Beispiel 29 ist ein computerlesbares Medium (z.B. ein Computerprogrammprodukt, ein nichtflüchtiges Speichermedium, ein nichttransitorisches Speichermedium, ein nichtvolatiles Speichermedium), welches Instruktionen speichern kann, die bei Ausführung durch einen Prozessor bewirken, dass der Prozessor eine Vorrichtung steuert, um das Verfahren gemäß einem oder mehreren des ersten Beispiels bis dem fünfzehnten Beispiel durchzuführen.

Es wird verstanden, dass der Träger in ein oder mehreren der Beispiele 1 bis 16 gemäß einem der Beispiele 17 bis 25 eingerichtet sein kann und dass der Träger in ein oder mehreren der Beispiele 1 bis 16 in der Prozesskammer auf einen Wafer-Chuck gemäß einem der Beispiele 26 bis 28 angeordnet werden kann.

## Patentansprüche

1. Verfahren (500), aufweisend:
• Einschleusen eines Trägers in eine Prozesskammer, wobei der Träger aufweist: eine Trägerplatte, einen auf der Vorderseite der Trägerplatte angeordneten Sensor, und einen ersten Elektrodenkontakt und einen zweiten Elektrodenkontakt zum Kontaktieren des Sensors (502);
• Koppeln des ersten Elektrodenkontaktes und des zweiten Elektrodenkontaktes mit einer in der Prozesskammer angeordneten Schnittstelle (504); und
• Anlegen eines Sensorsignals an den Sensor mittels der Schnittstelle (506).

2. Verfahren (500) gemäß Anspruch 1,
wobei der Aufbau der Prozesskammer beim Einschleusen des Trägers in die Prozesskammer nicht verändert wird.

3. Verfahren (500) gemäß Anspruch 1 oder 2,
wobei das Einschleusen des Trägers in die Prozesskammer aufweist:
• Anordnen des Trägers in einer mit der Prozesskammer gekoppelten Vorkammer,
• Evakuieren der Vorkammer,
• Öffnen eines Schiebers zwischen der Vorkammer und der Prozesskammer, und
• Transferieren des Trägers von der Vorkammer in die Prozesskammer; oder
wobei das Einschleusen des Trägers in die Prozesskammer aufweist:
• Transferieren des Trägers aus einem einheitlichen Frontöffnungs-Behälter in die Prozesskammer.

4. Verfahren (500) gemäß einem der Ansprüche 1 bis 3,
wobei der Sensor ein Schwingquarz ist; und
wobei das Verfahren ferner aufweist:
• Abscheiden einer Schicht auf dem in der Prozesskammer angeordneten Träger; und
• während des Anlegens des Sensorsignals an den Schwingquarz, Messen einer Resonanzfrequenz eines durch das Anlegen des Sensorsignals erzeugten Schwingkreises.

5. Verfahren (500) gemäß Anspruch 4, ferner aufweisend:
• Ermitteln einer Schichtdicke der abgeschiedenen Schicht unter Verwendung der gemessenen Resonanzfrequenz des Schwingquarzes.

6. Verfahren (500) gemäß Anspruch 4 oder 5,
wobei die Resonanzfrequenz des Schwingquarzes während des Abscheidens der Schicht gemessen wird und wobei das Verfahren ferner aufweist:
• Ermitteln einer Schichtabscheidungsrate während des Abscheidens der Schicht unter Verwendung der gemessenen Resonanzfrequenz des Schwingquarzes.

7. Verfahren (500) gemäß einem der Ansprüche 4 bis 6,
wobei die Schicht mittels chemischer Gasphasenabscheidung, vorzugsweise einer Atomlagenabscheidung, abgeschieden wird.

8. Verfahren (500) gemäß einem der Ansprüche 5 bis 7, ferner aufweisend:
• nach dem Abscheiden der Schicht, Ausschleusen des Trägers aus der Prozesskammer;
• Einschleusen des Trägers in eine andere Prozesskammer;
• Koppeln des ersten Elektrodenkontaktes und des zweiten Elektrodenkontaktes mit einer in der anderen Prozesskammer angeordneten anderen Schnittstelle; und
• Anlegen eines anderen Sensorsignals an den Schwingquarz mittels der anderen Schnittstelle.

9. Verfahren (500) gemäß Anspruch 8, ferner aufweisend:
• zumindest teilweises Entfernen der Schicht in der anderen Prozesskammer, wobei das andere Sensorsignal während des Entfernens der Schicht an den Schwingquarz angelegt wird; und
• während des Anlegens des Sensorsignals an den Schwingquarz, Messen einer Resonanzfrequenz des Schwingquarzes.

10. Verfahren (500) gemäß Anspruch 9,
wobei die Schicht nur teilweise entfernt wird und wobei das Verfahren ferner aufweist:
• Ermitteln einer Schichtdicke der Schicht nach dem teilweisen Entfernen der Schicht unter Verwendung der gemessenen Resonanzfrequenz des Schwingquarzes.

11. Verfahren (500) gemäß Anspruch 9 oder 10,
wobei die Resonanzfrequenz des Schwingquarzes während des Entfernens der Schicht gemessen wird und wobei das Verfahren ferner aufweist:
• Ermitteln einer Entfernrate während des Entfernens der Schicht unter Verwendung der gemessenen Resonanzfrequenz des Schwingquarzes.

12. Träger (100), aufweisend:
• eine Trägerplatte (102) mit einer ersten Seite (V) und einer der ersten Seite (V) gegenüberliegenden zweiten Seite (R);
• einen Schwingquarz (104) mit einer ersten Elektrode und einer zweiten Elektrode, wobei der Schwingquarz (104) zumindest teilweise auf der ersten Seite (V) der Trägerplatte (104) angeordnet ist; und
• einen ersten Elektrodenkontakt (106) und einen zweiten Elektrodenkontakt (108) auf der zweiten Seite (R) der Trägerplatte (102), wobei der erste Elektrodenkontakt (106) mit der ersten Elektrode des Schwingquarzes (104) elektrische leitend verbunden ist und wobei der zweite Elektrodenkontakt (108) mit der zweiten Elektrode des Schwingquarzes (104) elektrische leitend verbunden ist.

13. Träger (100) gemäß Anspruch 12, ferner aufweisend:
• einen anderen Schwingquarz (114) mit einer anderen ersten Elektrode und einer anderen zweiten Elektrode, wobei der andere Schwingquarz (114) zumindest teilweise auf der ersten Seite (V) der Trägerplatte (102) angeordnet ist; und
• einen anderen ersten Elektrodenkontakt (116) auf der zweiten Seite (R) der Trägerplatte (102);
• mindestens eine Durchkontaktierung (110), welche in der Trägerplatte (102) ausgebildet ist und die erste Elektrode des Schwingquarzes (104) mit dem ersten Elektrodenkontakt (106) elektrisch leitend verbindet;
• mindestens eine andere Durchkontaktierung (120), welche in der Trägerplatte (102) ausgebildet ist und die andere erste Elektrode des anderen Schwingquarzes (114) mit dem anderen ersten Elektrodenkontakt (116) elektrisch leitend verbindet;
• eine zumindest teilweise auf einer Oberfläche der Trägerplatte (102) derart ausgebildete Schicht, dass diese die zweite Elektrode des Schwingquarzes (104) und die andere zweite Elektrode des anderen Schwingquarzes (114) elektrisch leitend mit dem zweiten Elektrodenkontakt (108) verbindet.

14. Wafer-Chuck (200), aufweisend:
• eine Basisplatte (202) zum Tragen eines Wafers;
• mehrere elektrische Kontakte (206, 208, 216) zum Bereitstellen eines Signalwegs zu einem auf dem Wafer angeordneten Sensor, wenn der Wafer von der Basisplatte (202) getragen wird;
• eine mit den mehreren elektrischen Kontakten (206, 208, 216) elektrisch leitend verbundene Schnittstelle (210), welche derart eingerichtet ist, dass mittels der Schnittstelle (210) ein elektrisches Sensorsignal an die mehreren elektrischen Kontakte (206, 208, 216) angelegt werden kann.

15. Wafer-Chuck (200) gemäß Anspruch 14,
wobei mindestens ein elektrischer Kontakt der mehreren elektrischen Kontakte (206, 208, 216) derart angeordnet ist, dass dieser, wenn ein Wafer von der Basisplatte (202) getragen wird, in einem Abstand zu dem Wafer angeordnet ist.
